# EUROPÄISCHE PATENTSCHRIFT

(11) **EP 0 381 110 B1**
(45) Veröffentlichungstag und Bekanntmachung des Hinweises auf die Patenterteilung: **29.06.1994**
(21) Anmeldenummer: 90101717.8
(22) Anmeldetag: 29.01.1990
(51) Int. Cl.: C23C 16/26, H01L 23/29, H01L 21/56

(54) **Schutzschicht für elektroaktive Passivierschichten**
Protection layer for electroactive passivation layers
Couche de protection pour couches de passivation électroactives

(30) Priorität: 01.02.1989 DE 3902968
(43) Veröffentlichungstag der Anmeldung: 08.08.1990
(73) Patentinhaber: SIEMENS AKTIENGESELLSCHAFT, 80333 München (DE)
(72) Erfinder: Birkle, Siegfried, Dr., D-8552 Höchstadt/Aisch (DE); Kammermaier, Johann, Dr., D-8025 Unterhaching (DE); Schmidt, Gerhard, Dr., D-8550 Forchheim (DE); Schulte, Rolf, D-8520 Erlangen (DE)

(56) Entgegenhaltungen:
- US-A- 4 664 999
- US-A- 4 664 999
- Patents Abstracts of Japan, Band 11, Nr. 092 ((E-491), 24. March 1987; & JP-A-61 244 068
- Applied Physics Letters, Band 42, Nr. 8, New York, US; B. DISCHLER et al.: "Hard carbon coatings with low optical absorption", Seite 636, linke Spalte; Tafel 1,2.
- Patent Abstracts of Japan, Band 10, Nr. 215 (P-481), 26 July 1986; & JP-A-61 054 036
- Patent Abstracts of Japan, Band 10, Nr. 271 (P497), 16. September 1986; & JP-A-61 094 056

## Beschreibung

Die Erfindung betrifft eine Schutzschicht für elektroaktive Passivierschichten von Halbleiterbauelementen sowie ein Verfahren zu deren Herstellung.

Diskrete und integrierte Halbleiterbauelemente, insbesondere solche in MOS-Technologien, benötigen - aufgrund ihrer Empfindlichkeit gegen oberflächliche Aufladungen - elektroaktive Passivierschichten. Diese Passivierschichten müssen besondere Merkmale aufweisen: Isolation ≧ 10⁸Ω .cm; Defektdichte ≧ 10¹⁹ cm⁻³; gute elektrische Ankopplung. Als elektroaktive Passivierschichten sind insbesondere Schichten aus amorphem Silicium (a-Si) geeignet. Derartige Schichten können beispielsweise durch Aufdampfen oder Absputtern von einem Si-Target hergestellt werden (siehe dazu DE-OS 27 30 367).

Elektroaktive Passivierschichten der vorstehend genannten Art sind sehr feuchte- und kratzempfindlich und weisen darüber hinaus in beträchtlicher Anzahl sogenannte Pinholes auf; sie müssen deshalb durch eine harte, mechanisch und chemisch stabile Zweitschicht geschützt werden. Diese Schutzschicht darf jedoch die elektrischen Eigenschaften und die elektroaktive Passivierwirkung der darunterliegenden a-Si-Schicht nicht negativ beeinflussen.

In der IC-Technik und bei Einzeltransistoren wird auf Polysilicium bzw. a-Si zusätzlich Siliciumnitrid Si₃N₄, sogenanntes Plasmanitrid, als Feuchtesperre aufgebracht.

Diese Vorgehensweise wird insbesondere bei bipolaren Modulthyristoren mit Betriebsspannungen < 2000 V in der Serienproduktion seit einiger Zeit angewandt. Solange a-Si mit einer spezifischen Leitfähigkeit σ < 10⁻⁹ Ω⁻¹.cm⁻¹ eingestellt wird und eine metallische Kontamination der Oberfläche ausgeschlossen ist, spielt der Feuchteeinfluß in der Praxis allerdings eine untergeordnete Rolle. Probleme ergeben sich aber bei hochsperrenden Bauelementen mit Betriebsspannungen > 4000 V. In diesem Fall muß die a-Si-Schicht - für eine ausreichende elektrische Ankopplung an das Substrat - niederohmiger eingestellt werden; dadurch wird das Bauelement aber empfindlicher gegenüber Umwelteinflüssen und Kontamination. Es ist deshalb erforderlich, die a-Si-Schicht durch eine zweite, isolierende Schicht zu schützen, die als Diffusionsbarriere gegen Feuchte und Ionen wirkt. Plasmanitrid-Schichten sind für diesen Zweck nicht besonders geeignet, da derartige Schichten zu Rißbildung neigen und deshalb durch sie Wasser hindurchtreten kann.

Aufgabe der Erfindung ist es, eine harte, mechanisch und chemisch stabile Schutzschicht für elektroaktive Passivierschichten von Halbleiterbauelementen anzugeben, die auch als zuverlässige Diffusionsbarriere gegen Feuchte und Ionen wirkt.

Dies wird erfindungsgemäß dadurch erreicht, daß die Schutzschicht aus einer dünnen Schicht aus amorphem wasserstoffhaltigem Kohlenstoff (a-C:H) mit einer Defektdichte ≦ 10¹⁷ cm⁻³.eV⁻¹ und einem spezifischen elektrischen Widerstand ≧ 10¹⁰ Ω.cm besteht.

Amorpher wasserstoffhaltiger Kohlenstoff, kurz a-C:H, ist ein Kohlenstoffmaterial, bei dem ein amorphes Kohlenstoffnetzwerk vorliegt; aufgrund seiner mechanischen Härte wird dieses Kohlenstoffmaterial auch als diamantartiger Kohlenstoff bezeichnet (siehe beispielsweise: "IDR - Industrie Diamanten Rundschau", Bd. 18 (1984), Nr. 4, Seiten 249 ff.). Diese amorphe Modifikation von Kohlenstoff erhält ihre besonderen Eigenschaften, wie optische Transparenz, Mikrohärte, chemische Resistenz und elektrische Isolation, durch das Nebeneinander von tetraedrischer (sp³-) und trigonaler (sp²-) Hybridisierung sowie durch den Einbau von Wasserstoff (etwa 10 bis 40 Atom-%).

Aus der US-PS 4 664 999 ist ein Verfahren zur Herstellung eines elektrophotographischen Bauteils bekannt, wobei zunachst auf einem Substrat eine photoleitende Schicht aus amorphem Silicium (bzw. a-Si:H) abgeschieden wird und darauf eine Schutzschicht aus amorphem wasserstoffhaltigem Kohlenstoff. Diese a-C:H-Schicht muß hart sein, einen hohen elektrischen Widerstand aufweisen, d.h. nicht kleiner als 10¹³Ω.cm, und transparent sein, d.h. der optische Bandabstand darf nicht kleiner als 2,0 eV sein (US-PS 4 664 999: Spalte 4, Zeilen 4 bis 8). Eine derartige Schicht wird nur bei folgenden Bedingungen erhalten: Substrattemperatur: 100 bis 300 °C; Druck: 20 bis 40 Pa; Mischungsverhältnis C₂H₄/He: 2 bis 3; RF-Leistungsdichte: ≧ 0,2 W/cm² (Spalte 4, Zeilen 8 bis 11). Schichten mit einer Defektdichte ≦ 10¹⁷ cm⁻³.eV⁻¹ und einem spezifischen elektrischen Widerstand ≧ 10¹⁰Ω.cm sind aus der US-PS 4 664 999 nicht bekannt. Außerdem müssen die bekannten a-C:H-Schichten transparent sein, d.h. einen optischen Bandabstand ≧ 2 eV aufweisen. Derartige Schichten besitzen aber, wie eigene Untersuchungen gezeigt haben, einen H₂O-Permeationskoeffizienten ≧ 10⁻¹¹ m².s⁻¹. Dies gilt im Prinzip auch für den aus der JP-OS 62-178975 bekannten elektrophotographisch sensitiven Körper, bei dem sich auf einer Schicht aus amorphem Silicium eine Schutzschicht aus amorphem Kohlenstoff befindet (siehe: "Patent Abstracts of Japan", Bd. 12, Nr. 25 (P-659) (2872), 26. Januar 1988).

Aus "Appl. Phys. Lett.", Vol. 42 (1983), Seiten 636 bis 638, sind harte a-C:H-Schichten mit niedriger optischer Absorption bekannt. Diese Schichten werden aus gasförmigem Benzol - auf Substraten aus Ge, Si, Quarz oder Glas - unter folgenden Bedingungen hergestellt: RF-Frequenz: 2,3 MHz; Self-bias-Spannung: 0,4 bis 1,8 kV; Gasdruck: 10 bis 60 »bar (d.h. 1 bis 6 Pa); Abscheidetemperatur: 40 bis 140 °C; Wachstumsrate: 100 bis 2500 Å/min. Dabei wird a-C:H erhalten, der unter anderem folgende Eigenschaften aufweist: Härte (Knoop, 100 p): 1250 bis 1650 kp/mm²; optischer Bandabstand: 0,8 bis 1,8 eV; elektrischer Widerstand: 10¹² Ω.cm. Schichten mit den vorstehend genannten Eigenschaften sind aus dieser Druckschrift dagegen nicht bekannt. Die bekannten Schichten zeigen außerdem die für a-C:H im allgemeinen typischen hohen inneren Spannungen; dadurch sind diese Schichten aber spröde und bei Dehnung rißanfällig.

Die erfindungsgemäße Schutzschicht für elektroaktiv passivierte Halbleiterbauelemente in Form von a-C:H-Dünnschichten, die vorzugsweise eine Dicke etwa zwischen 0,05 und 3 »m aufweisen, erfüllt die an sie gestellten Forderungen in hohem Maße. Derartige Schichten besitzen nämlich diamantähnliche Eigenschaften, wie hohe mechanische Härte, Kratzfestigkeit, chemische Stabilität und niedrige Wasserpermeation. Der Werkstoff a-C:H läßt sich darüber hinaus, beispielsweise im Gegensatz zu a-Si und a-Si:H, mit variablem optischen Bandabstand, variabler Defektdichte und vor allem variablem elektrischen Widerstand herstellen. Für die erfindungsgemäße Schutzschicht sind a-C:H-Schichten mit niedriger Defektdichte, nämlich ≦ 10¹⁷ cm⁻³.eV⁻¹, bei einem spezifischen elektrischen Widerstand ≧ 10¹⁰Ω .cm (bei Raumtemperatur) vorgesehen. Durch derartige Schichten wird die elektrische Charakteristik und die elektroaktive Passivierwirkung der darunterliegenden Passivierschicht, die vorzugsweise aus a-Si besteht, nicht gestört; außerdem wird die Passivierschicht hervorragend mechanisch sowie gegen Feuchte geschützt.

Die erfindungsgemäße Schutzschicht aus a-C:H weist ferner den Vorteil auf, daß von diesem Material aus, aufgrund der stabilen C-H-Bindung, kein schädliches Eindiffundieren von Wasserstoff in den zu schützenden Halbleiteraufbau erfolgt; dies wäre beispielsweise aber bei a-Si:H der Fall. Darüber hinaus ist die Haftung von a-C:H-Schichten insbesondere auf Substraten, die aus Elementen der 4. Hauptgruppe des Periodensystems bestehen, außerordentlich gut, und zwar infolge einer chemischen Bindung über Carbide. Deshalb ergibt vor allem die Beschichtung von mit a-Si elektroaktiv passivierten Halbleiteraufbauten einen stabilen und gut haftenden Überzug, da zwischen a-Si und a-C:H eine Carbidbildung erfolgt.

Die Herstellung der erfindungsgemäßen Schutzschicht erfolgt in der Weise, daß auf eine elektroaktive Passivierschicht durch eine Hochfrequenz-Niederdruck-Plasmaabscheidung gasförmiger Kohlenwasserstoffe bei einer Self-biasSpannung bis zu etwa 1 kV und einem Druck von etwa 100 Pa eine dünne Schicht aus amorphem wasserstoffhaltigem Kohlenstoff aufgebracht wird. Die Plasmaabscheidung erfolgt dabei vorzugsweise mittels Radiofrequenz (RF), d.h. im Bereich zwischen 0,1 und 100 MHz, sie kann aber auch mittels Mikrowellen (MW) erfolgen, d.h. im Bereich zwischen 0,1 und 1000 GHz.

Als gasförmige Kohlenwasserstoffe dienen bei der Herstellung der erfindungsgemäßen Schutzschicht vorteilhaft Alkane, d.h. gesättigte aliphatische Kohlenwasserstoffe, wie Methan, Ethan und Propan; dabei wird Methan bevorzugt. Daneben können aber auch Alkene, d.h. ungesättigte aliphatische Kohlenwasserstoffe, wie Ethen und Propen, eingesetzt werden, sowie Acetylen, Cycloalkane, d.h. gesättigte cyclische Kohlenwasserstoffe, wie Cyclohexan, und - im dampfförmigen Zustand - aromatische Kohlenwasserstoffe in Form von Benzol und Benzolderivaten. Die Kohlenwasserstoffe der vorstehend genannten Art können einzeln oder im Gemisch zum Einsatz gelangen. Den Kohlenwasserstoffen können ferner Wasserstoff und/oder Edelgase, wie Helium und Argon, zugegeben werden.

In Hochfrequenzentladungen, insbesondere mit RF-Anregung, bildet sich bei unterschiedlich großen Innenelektroden der Entladungseinrichtung (Flächenverhältnis ≦ 0,5, vorzugsweise zwischen 0,25 und 0,05) - aufgrund von Raumladungen - eine im Takt der Hochfrequenz (HF) pulsierende Gleichstrom-Spannungskomponente (Vorspannung bzw. "self bias potential") bis zu etwa 1 kV aus. Diese DC-Spannungskomponente überlagert sich der HF-Wechselspannung und macht die kleinere Elektrode zur Kathode. Dadurch werden die geladenen CₓH_{y}-Teilchen, die durch Ionisierung und Fragmentierung des Reaktionsgases entstehen, zur Kathode hin beschleunigt und auf dem vor der Kathode angeordneten Substrat mit hoher kinetischer Energie - unter Bildung von a-C:H - abgeschieden. Um die Substrattemperatur möglichst niedrig zu halten (≦ 250 °C) und damit einen möglichst hohen sp³-Anteil im a-C:H zu erreichen (≧ 60 %), ist die Anode vorteilhaft topfförmig ausgebildet. Ein "self bias"-Effekt der vorstehend genannten Art ist, wenngleich - wegen des Fehlens von Innenelektroden - in sehr viel geringerem Ausmaß, auch bei MW-induzierten Abscheideplasmen wirksam, weil zwischen Plasma und Substratfläche in jedem Fall eine Potentialdifferenz besteht.

Anhand eines Ausführungsbeispiels wird die Erfindung noch näher erläutert.

In eine Apparatur zur Plasmaabscheidung von a-C:H mittels RF-Anregung in Form eines zylindrischen Glasgefäßes wird Methan CH₄ (als Reaktionsgas) bei einem Druck von 100 Pa eingeleitet. Das Reaktionsgas gelangt in das sich zwischen zwei ungleichen Elektroden (Flächenverhältnis 1:4) ausbildende Plasma mit einem Volumen von ca. 400 cm³. Die beiden Elektroden sind mit einem RF-Generator verbunden (ν = 13,56 MHz). Aufgrund der ungleichen Elektroden entsteht zwischen diesen eine - sich der RF-Spannung überlagernde - Self-bias-DC-Spannung, wobei die kleinere Elektrode, welche die zu beschichtenden, mit a-Si passivierten Halbleiterteile trägt, zur Kathode wird. Durch die a-Si-Schicht wird ein störender elektrischer Einfluß des Plasmas auf die Halbleiterbauelemente während der Beschichtung mit a-C:H weitgehend unterbunden.

Bei einer Hochfrequenz-Leistungsdichte von ca. 2,2 W.cm⁻², bezogen auf die Kathodenfläche, entsteht zwischen den beiden Elektroden eine Self-bias-DC-Spannung bis zu ca. 500 V. Unter diesen Bedingungen erhält man bei einem CH₄-Massedurchfluß von 8,8.10⁴ Pa.cm³.s⁻¹ nach 1 min (Abscheiderate: ca. 3 nm.s⁻¹) eine ca. 0,2 »m dicke a-C:H-Schicht mit diamantartigen Eigenschaften und einem H₂O-Permeations-koeffizienten ≦ 3.10⁻¹³ m².s⁻¹. Aufgrund des sehr hohen elektrischen Widerstandes (≧ 10¹⁰Ω .cm) und einer Defektdichte < 10¹⁷ cm⁻³.eV⁻¹ der a-C:H-Schicht wird die elektroaktive Passivierwirkung der darunterliegenden a-Si-Schicht nicht negativ beeinflußt.

## Patentansprüche

1. Schutzschicht für elektroaktive Passivierschichten von Halbleiterbauelementen, **dadurch gekennzeichnet,** daß sie aus einer dünnen Schicht aus amorphem wasserstoffhaltigem Kohlenstoff (a-C:H) mit einer Defektdichte ≦ 10¹⁷ cm⁻³.eV⁻¹ und einem spezifischen elektrischen Widerstand ≧ 10¹⁰ Ω .cm besteht.

2. Schutzschicht nach Anspruch 1, **dadurch gekennzeichnet,** daß sie eine Dicke etwa zwischen 0,05 und 3 »m aufweist.

3. Schutzschicht nach Anspruch 1 oder 2, **dadurch gekennzeichnet,** daß die elektroaktiven Passivierschichten aus amorphem Silicium bestehen.

4. Verfahren zur Herstellung einer Schutzschicht nach einem der Ansprüche 1 bis 3, **dadurch gekennzeichnet,** daß auf eine elektroaktive Passivierschicht durch eine Hochfrequenz-Niederdruck-Plasmaabscheidung gasförmiger Kohlenwasserstoffe bei einer Self-bias-Spannung bis zu etwa 1 kV und einem Druck von etwa 100 Pa eine dünne Schicht aus amorphem wasserstoffhaltigem Kohlenstoff aufgebracht wird.

5. Verfahren nach Anspruch 4, **dadurch gekennzeichnet,** daß die Plasmaabscheidung mittels Radiofrequenz erfolgt.

6. Verfahren nach Anspruch 4 oder 5, **dadurch gekennzeichnet,** daß als Kohlenwasserstoffe Alkane eingesetzt werden, insbesondere Methan.

7. Verfahren nach einem der Ansprüche 4 bis 6, **dadurch gekennzeichnet,** daß die elektroaktive Passivierschicht während der Abscheidung auf einer Temperatur ≦ 250°C gehalten wird.

## Claims

1. Protective layer for electroactive passivation layers of semiconductor components, characterized in that it consists of a thin layer of amorphous hydrogenated carbon (a-C:H) with a defect density ≦ 10¹⁷ cm⁻³.eV⁻¹ and a specific electrical resistance ≧ 10¹⁰ Ω.cm.

2. Protective layer according to claim 1, characterized in that it has a thickness of approximately between 0.05 and 3 »m.

3. Protective layer according to claim 1 or 2, characterized in that the electroactive passivation layers consist of amorphous silicon.

4. Method for producing a protective layer according to one of claims 1 to 3, characterized in that a thin layer of amorphous hydrogenated carbon is applied to an electroactive passivation layer by means of a high-frequency low-pressure plasma deposition of gaseous hydrocarbons with a self-bias voltage of up to about 1 kV and a pressure of about 100 Pa.

5. Method according to claim 4, characterized in that the plasma deposition takes place by means of radio frequency.

6. Method according to claim 4 or 5, characterized in that alkanes are used as hydrocarbons, in particular methane.

7. Method according to one of claims 4 to 6, characterized in that the electroactive passivation layer is kept at a temperature ≦ 250°C during the deposition.

## Revendications

1. Couche de protection pour des couches de passivation électro-actives de composants à semiconducteurs, caractérisée en ce qu'elle est constituée d'une couche mince en carbone amorphe contenant de l'hydrogène (a-C:H) ayant une densité de défauts ≦ 10¹⁷ cm⁻³.eV⁻¹ et une résistivité électrique ≧ 10¹⁰ Ω.cm.

2. Couche de protection suivant la revendication 1, caractérisée en ce qu'elle a une épaisseur comprise entre 0,05 et 3 »m environ.

3. Couche de protection suivant la revendication 1 ou 2, caractérisée en ce que les couches de passivation électro-actives sont en silicium amorphe.

4. Procédé de préparation d'une couche de protection suivant l'une des revendications 1 à 3, caractérisé en ce qu'il consiste à déposer sur une couche de passivation électro-active une couche mince en carbone amorphe contenant de l'hydrogène, par un dépôt au plasma à haute fréquence et à basse pression d'hydrocarbures gazeux avec une tension d'auto-polarisation atteignant jusqu'à environ 1 kV et une pression égale à environ 100 Pa.

5. Procédé suivant la revendication 4, caractérisé en ce qu'il consiste à effectuer le dépôt au plasma au moyen d'une radio fréquence.

6. Procédé suivant la revendication 4 ou 5, caractérisé en ce qu'il consiste à utiliser, comme hydrocarbures, des alcanes, notamment du méthane.

7. Procédé suivant l'une des revendications 4 à 6, caractérisé en ce qu'il consiste à maintenir, pendant le dépôt, la couche de passivation électro-active à une température ≦ 250°C.
